# EUROPÄISCHE PATENTSCHRIFT

(11) **EP 1 136 943 B1**
(45) Veröffentlichungstag und Bekanntmachung des Hinweises auf die Patenterteilung: **02.11.2006**
(21) Anmeldenummer: 01105893.0
(22) Anmeldetag: 09.03.2001
(51) Int. Cl.: G06K 19/077

(54) **Herstellungsverfahren für Transponder**
Manufacturing process for transponders
Procédé d'assemblage des transpondeurs

(30) Priorität: 16.03.2000 DE 10012967
(43) Veröffentlichungstag der Anmeldung: 26.09.2001
(73) Patentinhaber: Plettner, Andreas, Dr., 81669 München (DE)
(72) Erfinder: Plettner, Andreas, Dr., 81669 München (DE)
(74) Vertreter: Grünecker, Kinkeldey, Stockmair & Schwanhäusser Anwaltssozietät

(56) Entgegenhaltungen:
- WO-A-96/07938
- DE-A- 19 753 619
- FR-A- 2 761 527
- US-A- 5 786 626

## Beschreibung

Die vorliegende Erfindung bezieht sich auf ein Verfahren zur herstellung eines Transponders, enthaltend einen Chip mit Koppelelementen.

In vielen Bereichen wurden in den letzten Jahren verstärkt RFID-Systeme zur Identifikation von beliebigen Objekten eingesetzt. Der Term RFID steht hierbei für Radio-Frequency-ldentification und bezeichnet eine Identifikation mittels Radiowellen. Ein RFID-System besteht immer aus zwei Komponenten: einem Auswertegerät, das als Lese- und/oder Schreibeinheit ausgebildet sein kann, und einem Transponder, der die zur Identifikation verwendeten Daten trägt.

Aufgrund einer einfachen Handhabung und einer robusten Ausgestaltung weisen Transponder eine geringe Störanfälligkeit auf und bieten somit eine Reihe interessanter Möglichkeiten in der Anwendung. Deshalb werden Transponder bereits heutzutage in den verschiedensten Bereichen verwendet, beispielsweise in Zugangskontrollsystemen, eingebettet in Zugangstickets, Armbanduhren, Schlüsselanhängem oder Firmenausweisen, in Überwachungssystemen, eingebettet in Papier- oder Plastiketiketten, oder auch in Zahlungsmittelsystemen, eingebettet in kontaktlosen Chipkarten.

Die derzeit am häufigsten gefertigten Transponder enthalten auf einem Substrat ein Koppelelement, das mit einem kleinflächigen Chip verbunden ist. Das Koppelelement selbst ist entweder als Leiterschleife für eine überwiegend induktive Kopplung, oder als Dipol ausgebildet. Für den Fall, daß das Koppelelement als Dipol ausgebildet ist, kann der Transponder sowohl in einem sogenannten "Close-Coupling-System" wie auch in einem "Long-Range-System" verwendet werden.

Close-Coupling-Systeme sind RFID-Systeme mit sehr kleinen Reichweiten, in denen der Dipol des Transponders eine rein kapazitive Signaleinkopplung eines Auswertegeräts ermöglicht, das sich in einem geringen Abstand von ungefähr 0,1 cm bis 1 cm zu dem Transponder befindet und ebenfalls geeignete Elektrodenflächen aufweist. Zur Signaleinkopplung werden beide Dipole parallel zueinander plaziert und bilden somit Plattenkondensatoren, über die Daten und/oder Energie übertragen werden.

Bei Long-Range-Systemen können Reichweiten von 1 m bis 10 m Entfernung zwischen Transponder und Auswertegerät erzielt werden. In Long-Range-Systemen ist der Dipol als Dipol-Antenne ausgebildet und wird mit sehr hohen Frequenzen betrieben, die derzeit in Europa bei etwa 2,45 GHz bzw. 5,8 GHz liegen. Hierbei wird über ein Auswertegerät eine Leistung abgestrahlt, die an den Anschlüssen der Dipol-Antenne des Transponders als HF-Spannung bereitsteht und nach Gleichrichtung zur Versorgung des Chips verwendet wird.

Bei den derzeit gebräuchlichen Transpondern mit Dipol ist ein Chip oder ein Chipmodul über entsprechende Kontakte mit dem Dipol verbunden, um somit mit der Außenwelt kommunizieren zu können.

Gemäß diesem Stand der Technik erfolgt die elektrische Kontaktierung des Chips mit dem Dipol dadurch, daß der Chip auf ein Substrat aufgebracht wird, auf dem der Dipol ausgebildet ist und daß anschließend der Chip mit dem Dipol verbunden wird. Zur Erzielung dieser elektrischen Verbindung zwischen Dipol und Chip haben sich insbesondere die Verwendung von Chipmodulen, das sogenannte "Flip-Chip"-Verfahren sowie das Drahtbond-Verfahren durchgesetzt, die im Folgenden näher erläutert werden.

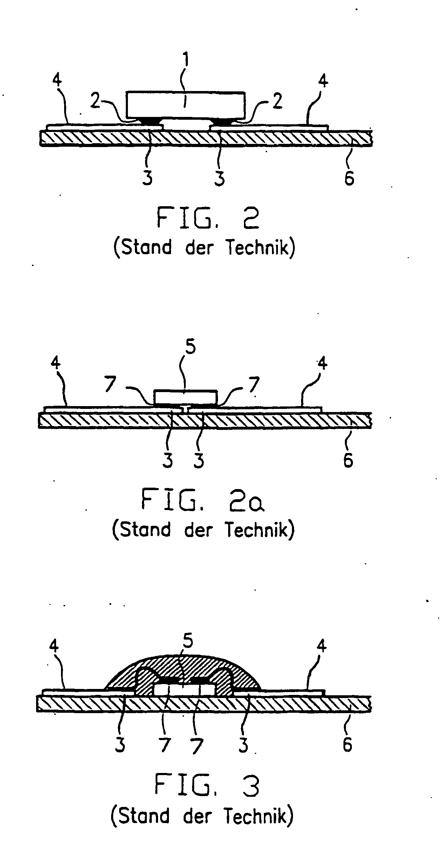

Fig. 2 verdeutlicht das Prinzip, wie nach dem Stand der Technik üblicherweise eine elektrische Verbindung zwischen einem Chipmodul 1 und einem Dipol 4 hergestellt wird.

Ein Chipmodul 1, in dessen Innerem sich ein nicht dargestellter Chip befindet, weist von außen zugängliche Kontakte 2 auf, die beispielsweise mittels eines Löt-, Klebe- oder Drahtbond-Prozesses mit den eigentlichen Kontakten des Chips verbunden sind. Mit der Bezugsziffer 3 sind Kontaktanschlüsse angedeutet, die unmittelbar mit dem auf einem Substrat 6 aufgebrachten Dipol 4 verbunden sind. Um letztendlich eine Kontaktierung zwischen dem Dipol 4 einerseits und dem Chip andererseits zu erreichen, müssen die Kontakte 2 mit den Kontaktanschlüssen 3 elektrisch leitend verbunden werden. Hierzu wird das Modul 1 mittels eines Werkzeuges mit der kontaktbehafteten Seite auf die Kontaktanschlüsse 3 aufgesetzt.

Eine andere Möglichkeit besteht darin, in einem Flip-Chip-Verfahren den Chip 5 selbst, d.h. nicht in Modulform, sondern "nackt" auf die Kontaktanschlüsse 3 aufzusetzen, wie in Fig. 2a dargestellt wird. Bei dieser Variante muß der Chip 5 mit seiner "aktiven Seite", d.h. der Seite, die die Anschlußflächen 7 trägt, auf die Kontaktanschlüsse 3 aufgesetzt werden. Hierzu muß der Chip "geflippt" werden, was ein zweifaches Greifen des Chips 5, beispielsweise von einem Trägerband, erforderlich macht.

Fig. 3 verdeutlicht die Möglichkeit, wie nach dem Stand der Technik eine elektrische Verbindung zwischen einem Chip 5 und einem Dipol 4 mittels eines Drahtbond-Verfahrens hergestellt werden kann.

Um in diesem Fall eine Kontaktierung zwischen dem Dipol 4 einerseits und dem Chip 5 andererseits zu erreichen, wird der Chip auf das Substrat 6 aufgebracht, und die Anschlußflächen 7 werden mittels Drahtbonden mit den Kontaktanschlüssen 3 elektrisch leitend verbunden. Ersichtlicherweise muß der Chip 5 bei dieser Lösung nicht mehr geflippt werden. Allerdings bedingen die durch das Drahtbonden entstandenen Drahtverbindungen eine größere gesamte Bauhöhe des Transponders und müssen außerdem durch eine solide Schutzschicht geschützt werden.

Aus US-A-5,786,626 ist ein Transpoder, enthaltend einen Chip mit Anschlussflächen und mindestens zwei Koppelelementen, welche elektrisch leitend mit den Anschlussflächen verbunden sind, bekannt. Die Koppelelemente sind dabei freistehend ausgebildet und verlaufen im Wesentlichen parallel zur Chipebene und die Koppelelemente sind in Größe und Geometrie so ausgeführt, dass sie als Dipol-Antenne wirken können.

Ausgehend von dem bekannten Stand der Technik liegt der vorliegenden Erfindung die Aufgabe zugrunde, ein effektives und kostengünstiges Verfahren zur Herstellung von Transpondern mit Dipol-Antennen anzugeben.

Diese Aufgabe wird durch den Gegenstand des Anspruchs 1 gelöst.

Bevorzugte Ausgestaltungen sind Gegenstand der Unteransprüche.

Gemäß einem besonderen Aspekt der vorliegenden Erfindung werden Transponder bereitgestellt, deren Koppelelemente unmittelbar mit den Anschlußflächen des Chips verbunden werden, wobei die Koppelelemente sich gegenseitig nicht berühren und selbsttragend sowie freistehend ausgebildet sind und sich im wesentlichen parallel zur Chipebene erstrecken. Des weiteren sind die Koppelelemente in Größe und Geometrie so ausgebildet, daß sie eine Signaleinkopplung eines Auswertegerätes ermöglichen, die entweder mittels hoher Frequenzen oder rein kapazitiv erfolgen kann. Insbesondere entspricht die Gesamtbauhöhe des Transponders aufgrund der flach abstehenden Koppelelemente im wesentlichen der Bauhöhe des Chips.

Gemäß der vorliegenden Erfindung werden die Koppelelemente unmittelbar auf Waferebene mit den Anschlußflächen des Chips verbunden, d. h. bevor die Chips aus der durch den Wafer vorgegebenen Gruppierung ausgelöst werden. Somit können die Koppelelemente von den jeweiligen Anschlußflächen in vertikaler Richtung abstehen, sodaß sie derart ausgebildet sind, daß sie ausgehend von dem jeweiligen Chip in horizontaler Richtung eine beispielsweise wellenförmige Form aufweisen. Die Koppelelemente liegen somit im wesentlichen nicht in der selben Ebene wie der Chip. Der wesentliche Vorteil dieser Ausführungsform beruht darauf, daß sich hierdurch auf einfache Art und Weise die wirksame Fläche der Koppelelemente vergrößern läßt. Insbesondere können die Koppelelemente auch mäanderförmig ausgeführt sein. Es ist zu erwähnen, daß die Koppelelemente nach dem Vereinzeln der erstellten Transponder nicht mehr vertikal von dem entsprechenden Chip abstehen, sondern vielmehr flach wie oben stehend beschrieben, da die Wellenförmigkeit ausschließlich durch ein Anbringen der Koppelelemente auf Waferebene entsteht.

Somit kann das weiter oben beschriebene, im Stand der Technik übliche, Umdrehen mittels Flip-Chip-Prozeß vermieden werden. Das Erzeugen einer Dipol-Struktur auf einem Substrat entfällt ebenfalls, da die Koppelelemente bzw. der Dipol auf Waferebene unmittelbar mit den Anschlußflächen des Chips verbunden werden, wodurch die Prozeßzeiten wesentlich verkürzt werden. Des weiteren erübrigt sich ein Kontaktieren des auf ein solches Substrat aufgebrachten Chips mittels Drahtbonden, sodaß ein verwendetes Substrat nur noch Träger- und/oder Schutzfunktion hinsichtlich des Transponders erfüllt. Insbesondere ist der erfindungsgemäße Transponder äußerst robust, da die Koppelelemente aufgrund ihrer Abmessungen und der vorzugsweise in entsprechender Größe ausgeführten Anschlußflächen hohen Zugbelastungen standhalten. Zusätzlich weisen die Koppelelemente eine hohe elektrische Zuverlässigkeit auf.

Für den Fall, daß ein Transponder auf ein Trägersubstrat aufgebracht werden soll, kann es wünschenswert sein, den Chip auf dem Substrat zu befestigen. Um ein Aufkleben des Chips selbst auf das Substrat zu vermeiden, wodurch die Prozeßzeiten durch ein Wegfallen der Verweilzeit beim Kleben verkürzt würden, können die Koppelelemente an ihren äußeren Enden mit dem Substrat verbunden werden. Der Chip ist somit nicht mit dem Substrat verbunden, was eine effiziente Zugentlastung des Chips bewirkt, da das Substrat gedehnt oder gebogen werden kann, ohne daß der Chip selbst beansprucht wird. Für den Fall, daß der Chip mit einer Abdeckmasse geschützt werden soll, kann eine Zugentlastung dadurch erreicht werden, daß die Abdeckmasse leichter dehnbar ist als das Substrat. Des weiteren kann der Schutz des Chips auch durch eine Abdeckfolie erreicht werden, die über den Chip und das Substrat auflaminiert wird, wobei eine klebende oder haftende Verbindung der Abdeckfolie mit dem Chip oder den Koppelelementen vermieden werden muß, um die oben beschriebene Zugentlastung aufrechtzuerhalten.

Für den Fall, daß ein Verbinden des Chips mit einem Substrat, z.B. mittels Kleben, wünschenswert ist, kann die oben beschriebene Zugentlastung des Chips dadurch erreicht werden, daß der verwendete Verbindungskleber zwischen Chip und Substrat so ausgewählt wird, daß dieser dehnbarer bzw. weicher als das Substrat ist. Des weiteren kann das Substrat selbst in der Umgebung des Chips dehnbarer sein und somit die Zugentlastung des Chips bewirken.

Gemäß der vorliegenden Erfindung werden Transponder auf Waferebene erstellt. Neben den oben beschriebenen Vorteilen weist dieses Verfahren insbesondere den Vorteil auf, daß eine effiziente Erstellung von Transpondern bereits auf Waferebene erfolgt und somit ein mühsames einzelnes Kontaktieren jedes individuellen Chips nicht mehr erforderlich ist. Es können somit quasi gleichzeitig ganze Reihen von Chips auf einem Wafer kontaktiert werden und für den Fall, daß die einzelnen Reihen des Wafers vorab in den richtigen Abstand zueinander gebracht werden, kann sogar ein quasi gleichzeitiges Kontaktieren aller Anschlußflächen der Chips mit einer über die Chips des Wafers gelegten Folie erreicht werden. Während der Erstellung der Transponder bleiben die Chips in einer Gruppierung zueinander bestehen, die im wesentlichen der durch die Waferherstellung vorgegebenen Gruppierung entspricht, wobei selbstverständlich eine Erweiterung der Abstände zwischen den einzelnen Chips durch geeignete Mittel erreicht werden sollte. Das Aufspreizen der einzelnen Chipreihen bzw. Chipspalten kann dabei durch geeignete feinmechanische Geräte erfolgen, wobei zur Sicherung der geeigneten Ausrichtung vorzugsweise eine Klebefolie zum Einsatz kommt.

Wie erwähnt, können die Anschlußflächen der Chips zumindest reihen- oder spaltenweise quasi gleichzeitig kontaktiert werden für den Fall, daß Kontaktfolien Verwendung finden, die die Breite des gesamten Wafers abdecken. Alternativ können als Folien auch Bänder verwendet werden, die jeweils über Reihen oder Spalten von Chips abgerollt werden.

Bevorzugte Ausführungsformen der vorliegenden Erfindung werden im folgenden unter Bezugnahme auf die beiliegenden Zeichnungen näher erläutert. Dabei zeigen die Zeichnungen im einzelnen:
Fig. 1 eine Draufsicht auf verschiedene Ausführungsformen von Transpondern gemäß der vorliegenden Erfindung;
Fig. 1a schematische Draufsichten auf mäanderförmige Antennenstrukturen;
Fig. 2 und 2a schematische Darstellungen einer Modul- bzw. Chipkontaktierung gemäß dem Stand der Technik, und
Fig. 3 eine schematische Darstellung einer Chipkontaktierung gemäß dem Stand der Technik mittels Drahtbondverfahren.

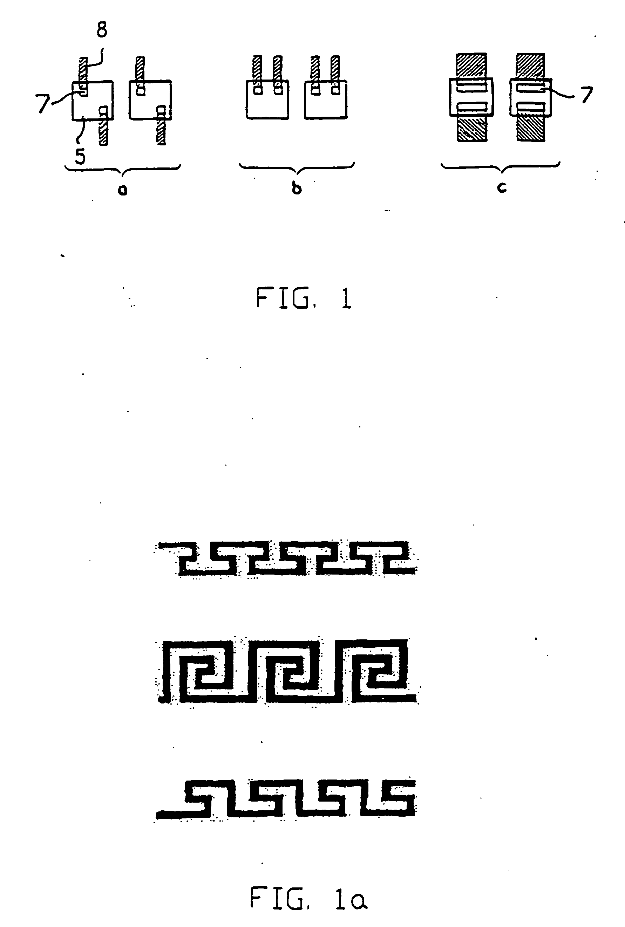

Fig. 1 zeigt verschiedene Draufsichten auf Transponder, enthaltend einen Chip 5 und Koppelelemente 8, die mit Anschlußflächen 7 des Chips 5 elektrisch leitend verbunden sind. Die verschiedenen Draufsichten a) bis c) sind Beispiele von möglichen Ausführungsformen des erfindungsgemäßen Transponders, bei denen die Koppelelemente 8 beispielhaft in 3 verschiedenen Größen ausgeführt sind. Es ist zu erwähnen, daß auch andere geometrische Formen und Größen für die Koppelelemente 8 möglich sind.

Insbesondere sind die Koppelelemente 8 der gezeigten Transponder selbst als Dipol ausgebildet und unmittelbar mit den Anschlußflächen 7 des Chips 5 elektrisch leitend verbunden, sodaß ein Ausbilden von Koppelelementen 8 auf einem Substrat entfällt, wodurch die Prozeßzeiten wesentlich verkürzt werden. Des weiteren erübrigt sich ein Kontaktieren des auf ein solches Substrat aufgebrachten Chips 5 mittels Drahtbonden, sodaß ein verwendetes Substrat nur noch Träger- und/oder Schutzfunktion hinsichtlich des Transponders erfüllt. Ebenso kann das, im Stand der Technik übliche, Umdrehen mittels Flip-Chip-Prozeß vermieden werden. Insbesondere ist der erfindungsgemäße Transponder äußerst robust, da die Koppelelemente 8 aufgrund ihrer Abmessungen und der vorzugsweise in entsprechender Größe ausgeführten Anschlußflächen 7 hohen Zugbelastungen standhalten. Zusätzlich weisen die Koppelelemente 8 eine hohe elektrische Zuverlässigkeit auf.

Wie man anhand von Fig. 1 erkennt, berühren die Koppelelemente 8 sich gegenseitig nicht, sind selbsttragend sowie freistehend ausgebildet und erstrecken sich im wesentlichen parallel zur Chipebene. Hierbei entspricht die Gesamtbauhöhe des Transponders aufgrund der flach abstehenden Koppelelemente 8 im wesentlichen der Bauhöhe des Chips 5. Des weiteren sind die Koppelelemente 8 in Größe und Geometrie so ausgebildet, daß sie eine Signaleinkopplung eines Auswertegerätes ermöglichen, die entweder mittels hoher Frequenzen oder rein kapazitiv erfolgen kann.

Gemäß einer bevorzugten Ausführungsform der vorliegenden Erfindung werden die Koppelelemente 8 als Dipol-Antenne ausgebildet, sodaß der Transponder in einem Long-Range-System verwendet werden kann. In solch einem Long-Range-System wird der Transponder mit hohen Frequenzen im GHz-Bereich betrieben, wobei die Frequenzen vorzugsweise bei etwa 2,45 GHz bzw. 5,8 GHz liegen, wobei die Länge der Koppelelemente 8 jeweils an die verwendete Betriebsfrequenz angepaßt wird, um eine HF-Kopplung zu ermöglichen.

Für den Fall, daß die Koppelelemente 8 als λ/2-Dipol-Antenne ausgebildet werden und die Betriebsfrequenz beispielsweise 5,8 GHz beträgt, ergibt sich die Wellenlänge zu ungefähr 5,1 cm. Somit muß die Dipol-Antenne bei einem gebräuchlichen Gewinn von ungefähr 1,64 eine wirksame Fläche von ungefähr 3,4 cm² aufweisen. Aufgrund der Antennenlänge von ungefähr 2,5 cm (λ/2) müßte jedes Koppelelement 8, beispielsweise in einer rechteckigen Ausführungsform, eine Breite von ungefähr 1,3 cm aufweisen. Zur Erzielung einer derartigen Länge des Koppelelements 8 kann dieses mäanderförmig ausgebildet sein, beispielsweise gemäß einer der in Fig. 1a gezeigten Strukturen.

Eine Möglichkeit zur Verringerung der Koppelelement-Längen ist die Verwendung einer entsprechend hohen Betriebsfrequenz. Sollen die Koppelelemente 8 wiederum als λ/2-Dipol ausgebildet werden und der entsprechende Transponder bei einer Frequenz von 24,125 GHz arbeiten, was einer Wellenlänge von ungefähr 1,2 cm entspricht, so muß die wirksame Fläche der Koppelelemente 8 nur noch jeweils ungefähr 0,2 cm² betragen. Somit würde bei der obenstehend erwähnten Ausbildung des Koppelelements 8 nur noch eine Breite von ungefähr 0,7 cm benötigt.

Gemäß einer weiteren bevorzugten Ausführungsform der vorliegenden Erfindung sind die Koppelelemente 8 derart bemessen, daß die leitenden Flächen der Koppelelemente 8 in Zusammenwirkung mit einem Auswertegerät als Kondensatorplatten wirken können und somit eine nutzbare Koppelkapazität zur kapazitiven Kopplung des Transponders mit dem Auswertegerät darstellen, sodaß der Transponder in einem Close-Coupling-System verwendet werden kann.

Für eine rein kapazitive Kopplung müssen die als Kondensatorplatten wirkenden Koppelelemente 8 eine Kapazität von einigen pF aufweisen. Für den Fall, daß die Kapazität beispielsweise 3 pF betragen soll und das der Transponder in einer Distanz von ungefähr 1 mm zu einem Auswertegerät arbeitet, müßten die Koppelelemente 8 ungefähr eine Fläche von jeweils ungefähr 3,4 cm² aufweisen. Geht man hierbei von einer heutzutage gebräuchlichen Größe eines Chips 5 von 9 mm² aus, d. h. 3 x 3 mm, bei dem die Koppelelemente 8 rechteckig ausgehend von der Breite des Chips 5 ausgebildet werden, führt dies zu einer Breite von ungefähr 11,3 cm. Dies kann eine Verwendung entsprechender Transponder beispielsweise in Schlüsselanhängern oder Zugangstickets unmöglich machen. Deshalb werden die Koppelelemente vorzugsweise quadratisch mit einer Seitenlänge von ungefähr 1,8 cm ausgeführt. Des weiteren können die Koppelelemente 8 ebenfalls in verschiedenen anderen geometrischen Formen ausgebildet werden, wie beispielsweise Kreisen oder Fünfecken.

Es ist zu erwähnen, daß die oben angegebenen Werte von verschiedenen physikalischen Größen abhängig sind, die Einfluß auf die Abmessungen des jeweiligen Dipols haben können. Beispielsweise, wenn ein erfindungsgemäßer Transponder in Papier eingebettet wird, um den Chip und die Koppelelemente zu schützen, ändert sich die zu berücksichtigende Dielektrizitätskonstante und somit die Größe der wirksamen Dipolfläche.

Insbesondere kann eine effiziente Erstellung von Transpondern bereits auf Waferebene erfolgen, sodaß ein mühsames einzelnes Kontaktieren jedes individuellen Chips 5 nicht mehr erforderlich ist. Es können somit quasi gleichzeitig ganze Reihen von Chips auf einem Wafer (nicht gezeigt) kontaktiert werden für den Fall, daß als Koppelelemente 8 Bänder verwendet werden, die jeweils über Reihen oder Spalten von Chips 5 abgerollt werden. Für den Fall, daß die einzelnen Reihen des Wafers (nicht gezeigt) vorab in den richtigen Abstand zueinander gebracht werden, kann sogar ein quasi gleichzeitiges Kontaktieren aller Anschlußflächen 7 der Chips 5 mit einer über die Chips 5 des Wafers (nicht gezeigt) gelegten Folie (nicht gezeigt) erreicht werden. Während der Erstellung der Transponder bleiben die Chips 5 in einer Gruppierung zueinander bestehen, die im wesentlichen der durch die Waferherstellung vorgegebenen Gruppierung entspricht, wobei selbstverständlich eine Erweiterung der Abstände zwischen den einzelnen Chips 5 durch geeignete Mittel erreicht werden sollte. Das Aufspreizen der einzelnen Chipreihen bzw. Chipspalten kann dabei durch geeignete feinmechanische Geräte erfolgen, wobei zur Sicherung der geeigneten Ausrichtung vorzugsweise eine Klebefolie zum Einsatz kommt.

Insbesondere können die Koppelelemente bei einer Kontaktierung mit den Anschlußflächen des Chips unmittelbar auf Waferebene, d. h. bevor die Chips aus der durch den Wafer vorgegebenen Gruppierung ausgelöst werden aufgebracht werden. Somit können die Koppelelemente von den jeweiligen Anschlußflächen in vertikaler Richtung abstehen, sodaß sie derart ausgebildet sind, daß sie ausgehend von dem jeweiligen Chip in horizontaler Richtung eine beispielsweise wellenförmige Form aufweisen. Die Koppelelemente liegen somit im wesentlichen nicht in der selben Ebene wie der Chip. Somit kann auf einfache Art und Weise die wirksame Fläche der Koppelelemente vergrößern werden. Des weiteren können die Koppelelemente auch mäanderförmig ausgeführt werden. Es ist zu erwähnen, daß die Koppelelemente nach dem Vereinzeln der erstellten Transponder nicht mehr vertikal von dem entsprechenden Chip abstehen, sondern vielmehr flach, wie oben stehend beschrieben.

## Patentansprüche

1. Verfahren zur Herstellung von Transpondem, jeweils enthaltend einen Chip (5) mit Anschlussflächen (7) und mindestens zwei Koppelelementen (8), die elektrisch leitend mit den Anschlussflächen (7) verbunden werden, wobei das Verfahren die folgenden Schritte aufweist:
Bereitstellen einer Anzahl vorgefertigter Chips (5) mit Anschlussflächen (7), in einer durch einen Wafer vorgegebenen Gruppierung;
Bereitstellen einer metallisierten Kunststoff-Folie bzw. metallischen Folie zum Ausbilden von Koppelelementen (8);
Herstellen von Transpondern durch Verbinden der metallisierten Kunststoff-Folie bzw. metallischen Folie mit den Anschlussflächen (7) der Chips (5), wobei vor, während oder nach dem Verbinden die Koppelelemente (8) aus der Folie ausgebildet werden und wobei diese Koppelelemente (8) in Größe und Geometrie derart ausgeführt werden, dass sie als Dipol-Antenne oder, in Zusammenwirkung mit einem Auswertegerät, als Plattenkondensator wirken; und
Auslösen der einzelnen Transponder aus der durch den Wafer vorgegebenen Gruppierung derart, dass die Koppelelemente (8) der ausgelösten Transponder selbsttragend und freistehend sind, und sich im wesentlichen parallel zur Chipebene erstrecken, sodass die Gesamtbauhöhe des Transponders im wesentlichen der Bauhöhe des Chips (5) entspricht.

2. Verfahren nach Anspruch 1, **dadurch gekennzeichnet, dass** die Koppelelemente (8), die als Dipol-Antenne ausgebildet werden, derart ausgeführt werden, dass sie sich für einen Betrieb mit einer Arbeitsfrequenz von mehr als 2,45 GHz eignen.

3. Verfahren nach Anspruch 1 oder 2, **dadurch gekennzeichnet, dass** die Koppelelemente (8), die als Dipol-Antenne ausgebildet werden, derart ausgeführt werden, dass sie sich für einen Betrieb mit einer Arbeitsfrequenz von mindestens 24,125 GHz eignen.

4. Verfahren nach einem der Ansprüche 1 bis 3, **dadurch gekennzeichnet, dass** die Koppelelemente (8), die als Dipol-Antenne ausgebildet werden, mäanderförmig ausgeführt werden.

## Claims

1. A method of manufacturing transponders, each comprising a chip (5) having contact pads (7) and at least two coupling elements (8), which are conductively connected with the contact pads (7), the method comprising the steps of:
providing a plurality of pre-fabricated chips (5) having contact pads (7), in a grouping given by a wafer;
providing a metallized plastic film or a metallic film for forming coupling elements (8);
manufacturing transponders by connecting the metallized plastic film or the metallic film with the contact pads (7) of the chips (5), whereby before, during or after the connecting the coupling elements (8) are formed out of the film and wherein said coupling elements (8) are in geometry and size configured for acting as a dipole antenna or in conjunction with an evaluation unit as a plate capacitor; and
extracting the individual transponders from the grouping defined by the wafer such that the coupling elements (8) of the extracted transponders are self-supporting and free-standing and essentially extended parallel to the chip plane, so that the total mounting height of the transponder corresponds essentially to the mounting height of the chip (5).

2. The method of claim 1, **characterized in that the** coupling elements (8), which are formed as a dipole antenna, are formed for operation at a working frequency of more than 2.45 GHz.

3. The method of claim 1 or 2, **characterized in that** the coupling elements (8), which are formed as a dipole antenna, are formed for operation at a working frequency of at least 24.125 GHz.

4. The method of one of claims 1 to 3, **characterized in that** the coupling elements (8), which are formed as a dipole antenna, are formed in a meandrous way.

## Revendications

1. Procédé pour la fabrication de transpondeurs, comportant chacun une puce (5) avec des surfaces de connexion (7) et au moins deux éléments de couplage (8) qui sont électriquement raccordés aux surfaces de connexion (7), ledit procédé comprenant les étapes suivantes :
préparation d'un certain nombre de puces préfabriquées (5) avec des surfaces de connexion (7), selon un groupement défini par une plaquette ;
préparation d'un film plastique métallisé ou d'un film métallique pour la formation d'éléments de connexion (8) ;
fabrication de transpondeurs par raccordement du film plastique métallisé ou du film métallique avec les surfaces de connexion (7) des puces (5), dans lequel les éléments de couplage (8) sont formés à partir du film avant, pendant ou après le raccordement, et dans lequel ces éléments de couplage (8) sont réalisés avec une grandeur et une géométrie leur permettant de fonctionner en tant qu'antenne dipôle ou en tant que condensateur à plaques en coopération avec un appareil d'évaluation ; et
dégagement des différents transpondeurs du groupement défini par la plaquette, de manière que les éléments de couplage (8) des transpondeurs dégagés soient autoportants et autonomes, et s'étendent sensiblement parallèlement au plan de puce, si bien que la hauteur de montage totale du transpondeur corresponde sensiblement à la hauteur de montage des puces (5).

2. Procédé selon la revendication 1, **caractérisé en ce que** les éléments de couplage (8) qui sont formés en tant qu'antenne dipôle, sont réalisés de manière à être appropriés à un fonctionnement avec une fréquence de travail supérieure à 2,45 GHz.

3. Procédé selon la revendication 1 ou 2, **caractérisé en ce que** les éléments de couplage (8) qui sont formés en tant qu'antenne dipôle sont réalisés de manière à être appropriés à un fonctionnement avec une fréquence de travail d'au moins 24,125 GHz.

4. Procédé selon l'une des revendications 1 à 3, **caractérisé en ce que** les éléments de couplage (8) qui sont formés en tant qu'antenne dipôle, sont réalisés avec une forme en méandres.
